# EUROPEAN PATENT APPLICATION

(11) **EP 3 936 983 A1**
(43) Date of publication of application: **12.01.2022**
(21) Application number: 21183100.3
(22) Date of filing: 01.07.2021
(51) Int. Cl.: G06F 3/039, G06F 3/044

(54) **SYSTEM FOR DETECTING A CLICKED STATE AND AN UNCLICKED STATE OF A BUTTON FOR CAPACITIVE TOUCH DEVICE**

(30) Priority: 06.07.2020 EP 20184293
(71) Applicant: Advanced Silicon SA, 1007 Lausanne (CH)
(72) Inventor: Ballan, Hussein, 1806 St-Légier (CH); Mamaghanian, Hossein, 1022 Chavannes-près-Renens (CH)
(74) Representative: P&TS SA (AG, Ltd.)

(57) **Abstract**

The present invention concerns a button (1) for a capacitive touch device (5), comprising a support member (10) with a contact member (14), with at least a couple (143) of lower contacts (144', 144").

One lower contact of the couple faces a drive electrode and the other faces a non-adjacent sense electrode of the capacitive touch device (5).

The button comprises also an activation member (20), movable by a user relative to the support member (10), comprising a switch member (263) configured to:
- conductively connect the lower contacts (144', 144"), thereby closing a charge path (6) from the drive electrode and the non-adjacent sense electrode, when the button is in the clicked state, and
- conductively separate the lower contacts (144', 144"), when the button is in the unclicked state, so as to open the charge path (6).

A mutual capacitance facing one of the lower contacts is modified once the charge path (6) is closed respectively opened, thereby allowing the capacitive touch device (5) to detect the clicked state respectively the unclicked state of the button (1).

## Description

### Technical domain

The present invention concerns a system for detecting a clicked state and an unclicked state of a button for capacitive touch device, and a method for allowing a capacitive touch device to detect a clicked state and an unclicked state of this button.

### Related art

It is known in many application fields, e.g. the slot machines field or the avionic field, to use touch devices (or touch screens), in particular capacitive touch devices, with mechanical or electro-mechanical buttons on the capacitive touch surface. Often, the buttons are transparent or configured to display information under the button itself.

In the state of the art, it is known a click mechanism for a button, which moves a click detection portion closer to the capacitive touch surface, when the click mechanism is activated. This mechanism has however the disadvantage that the movable click detection portion is sometimes not brought close enough to the touch sensor surface, such that the click is sometimes not correctly detected.

An alternative is to avoid the mechanical click mechanism and to detect a click only, when a finger touch a defined user contact surface on the button. The user contact surface of the button is connected via an ohmic path to the click detection portion, placed in general on the capacitive touch surface, such that a capacitive change is detected in the capacitive touch sensor layer under the click detection portion, when the finger touches the user contact surface. This might provide a more reliable detection of the click. However, this has the disadvantage that the user is not able to haptically feel and/or to hear the click, due to the missing click mechanism.

Another alternative is to connect the user contact surface of the button to the click detection portion via a capacitive path. This is possible by adding in the button a (transparent) conductive layer capacitively connected to the user contact surface. An example of such a button is described in the document EP180159984, filed by the applicant. The user of the described button is not able to haptically feel and/or to hear the click.

Some known solutions use a mechanical engine below the capacitive touch screen, so as to generate a vibration to simulate a haptic feedback. Those solutions are costly and involve many extra moving parts and electric engines.

The document EP3537271, filed by the applicant, describes a button for capacitive touch screen with a transparent conductive layer on the activation member.

The document EP3537266, filed by the applicant, describes a button comprising a (transparent) conductive layer capacitively connected to the user contact surface and switch means as a dome-shaped spring allowing to haptically feel and/or to hear the click of the user. The charge path in this case is both capacitive, since the presence of the (transparent) conductive layer, but also ohmic, since the presence of the switch means.

The button described in both documents filed by the applicant exploits the body of the user as part of the charge path. In other words, the user's body acts as a ground when the user touches the user contact surface of the button. The capacitance measured by the capacitive touch device changes because of the capacitive connection between the capacitive touch device and the ground via the charge path, which is both in the button and in the body's user.

In fact, once the button is in its clicked state, the floating end of the capacitance of the button is connected to the ground via the capacitance of the user's body (which is in series with the capacitance of the button). Due to the presence of the (transparent) conductive layer, the charges of a human finger are connected over a capacitance between the user and the transparent conductive layer to the click detection portion and then to the capacitive touch surface. Therefore, it is possible to detect the user's finger on the button.

However, in order to safely detect the user's finger, and then the clicked state of the button, the capacitance between the finger and the (transparent) conductive layer must be as large as possible, and then the thickness of the (transparent) conductive layer must be as small as possible. Making the thickness of the (transparent) conductive layer as small as possible is expensive and complex. Therefore, the realisation of such button is expensive and complex.

The conductive transparent layer should be encapsulated, such that the material of the (thin) transparent conductive layer is protected from physical damages and/or is not in contact with air or with the finger pressing on the user contact surface of the activation member and/or such that the material does not chemically react with the ambient air, in particular does not oxidize. Moreover, if the transparent conductive layer is exposed, liquid and other conductive objects on the user contact surface could interfere with the click functionality. This encapsulation renders the realisation of such button more expensive and complex.

Moreover, the (thin) transparent conductive layer needs to be kept clean, so as to render reliable the contact with the user's body and then the detection of the touch. Therefore, the use of such button is complicated, as the cleaning of the transparent conductive layer should be performed regularly.

Finally, a contact with the user's body should be ensured: therefore it is not possible to detect a click state with any non-conductive objects, like gloves. Therefore, there is a difference between capacitance value changes made by an operation with an insulator, e.g. a gloved hand, on the user contact surface and capacitance value changes made by an operation with a bare hand on the user contact surface.

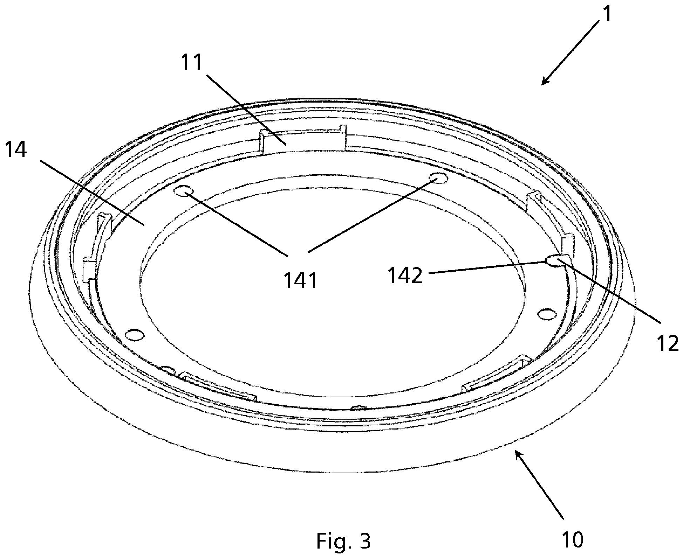

The document US2017123562 describes an object for use with a capacitive-touch-sensing device, which comprises a plurality of conductive regions and a switching arrangement connected to the conductive regions and arranged to connect two conductive regions. This document describes also a sensing device with a sensing mat comprising a capacitive sensing electrode array, and a sensing module coupled to the sensing mat for detecting an image and comparing the image to a reference image so as to determine if the button is in a clicked/unclicked state. In this document, the *image* of the conductive regions, whose pattern can change depending on the switch action, does trigger the active/non active state of the button. The upper part of Figure 3 shows that in the unclicked state, the image comprises two alias or ghost images of two conductive regions (321 and 322), and the lower part of Figure 3 shows that in the clicked state, the image comprises not only two alias or ghost images of the two conductive regions (321 and 322), but also two *additional* alias or ghost images of the two conductive regions (341 and 342). In other words, the active/non active state of the button is not triggered by a capacitance change of the same conductive regions detected in the unclicked state, but produces additional conductive regions that are detected as images.

The document US2020064951 describes an input device including a capacitive detector with a detection surface forming an array of electrodes. According to a main embodiment, the device is a rotative button, i.e. the capacitive variation is induced by changing the position of a pair of connected electrodes relatively to electrodes arrays and not induced by modifying the length of a path of charge.

The US2014042004 document turning knob that can be disposed on a touch panel to control it. The knob further comprises buttons that can be pushed by a user

### Short disclosure of the invention

An aim of the present invention is the provision of a system for detecting a clicked state and an unclicked state of a button for a capacitive touch device that overcomes the shortcomings and limitations of the state of the art.

Another aim of the invention is the provision of a system for detecting a clicked state and an unclicked state of a button for a capacitive touch device, wherein the button is less expensive than the known buttons.

Another aim of the invention is the provision of a system for detecting a clicked state and an unclicked state of a button for a capacitive touch device, wherein the button is less complex than the known buttons.

Another aim of the invention is the provision of a system for detecting a clicked state and an unclicked state of a button for a capacitive touch device, wherein the use of the button is less complex than the known buttons, in particular whose use does not require cleaning steps.

Another aim of the invention is the provision of a system for detecting a clicked state and an unclicked state of a button, reducing also the difference between capacitance value changes made by an operation with an insulator, e.g. a gloved hand, on the user contact surface and capacitance value changes made by an operation with a bare hand on the user contact surface.

Those aims are achieved by the system for detecting a clicked state and an unclicked state of a button according to claim 1 and to the method according to claim 15.

The dependent claims refer to further advantageous embodiments.

In the system for detecting a clicked state and an unclicked state of a button according to the invention, the button is configured to be placed on a capacitive touch surface of a capacitive touch device and is configured to allow the capacitive touch device to detect a clicked state and an unclicked state of the button.

The capacitive touch device on which the button according to the invention is placed comprises:
- drive conductive lines, each line serially connecting drive electrodes and being arranged to receive a drive signal,
- sense conductive lines, each line serially connecting sense electrodes and being arranged to be sensed, so as to determine mutual capacitances between adjacent drive electrodes and sense electrodes.
The drive conductive lines and the sense conductive lines are arranged in an array form.

In one preferred embodiment, the drive electrodes and the sense electrodes have a diamond shape. In one preferred embodiment, the drive electrodes and the sense electrodes have the same diamond shape. In one preferred embodiment, the drive electrodes and the sense electrodes have the same diamond shape and the same size.

The button according to the invention comprises a support member and an activation member.

The support member is configured to face the capacitive touch surface and comprises a contact member, comprising a lower surface configured to be placed on the capacitive touch surface, and comprising at least a couple of lower contacts; according to the invention the lower contacts are arranged so that one lower contact of the couple faces a drive electrode and the other lower contact of the couple faces a non-adjacent sense electrode.

In this context, a sense electrode non-adjacent with a drive electrode is a sense electrode not forming with this drive electrode a touch pixel, i.e. a mutual capacitance whose value is sensed by the capacitive touch device so as to detect a touch. On the contrary, in this context, a sense electrode adjacent with a drive electrode is a sense electrode forming with this drive electrode a touch pixel.

The activation member is movable by a user relative to the support member: in particular, the activation member in the clicked state is moved closer to the support member than in the unclicked state. The activation member comprises a user contact surface which is configured to be touched by a user for moving the activation member, thereby actuating the button.

According to the invention, the activation member comprises also a switch member, configured to
- conductively connect the lower contacts of the couple, thereby closing a charge path from the drive electrode and the non-adjacent sense electrode facing the lower contacts of the couple, when the button is in the clicked state, and
- conductively separate the lower contacts of the couple, when the button is in the unclicked state, so as to open the charge path.

According to the invention, a mutual capacitance facing one of the lower contacts of the couple is modified once the charge path is closed respectively opened by the switch member, thereby allowing the capacitive touch device to detect the clicked state respectively the unclicked state of the button.

In one preferred embodiment, this (same) mutual capacitance has a first value, when the button is in the clicked state, and a second value, different from the first, when the button is in the unclicked state. Since the first value is different from the first, the capacitive touch device is arranged to detect the clicked state respectively the unclicked state of the button.

The button according to the invention allows the capacitive touch device to detect a clicked state and an unclicked state of the button by exploiting the change of the value of a (same) mutual capacitance between a drive electrode and a sense electrode of the capacitive touch device.

Therefore, the button according to the invention is devoid of a thin (transparent) conductive layer capacitively connected to the user contact surface. The button according to the invention is therefore less expensive and less complex to realise. Moreover, this button does not require cleaning steps.

It also obviates the necessity for the human body to act as a ground. This reduces also the difference between capacitance value changes made by an operation with an insulator, e.g. a gloved hand, on the user contact surface and capacitance value changes made by an operation with a bare hand on the user contact surface.

In other words, the charge path allowing the modification of the mutual capacitance so as to detect a clicked state and an unclicked state of the button, does not comprise the user's body.

The present invention concerns also a method for allowing a capacitive touch device to detect a clicked state and an unclicked state of a button configured to be placed on a capacitive touch surface of this capacitive touch device, wherein the capacitive touch device comprises:
- drive conductive lines, wherein each line serially connects drive electrodes and is arranged to receive a drive signal,
- sense conductive lines, wherein each line serially connects sense electrodes and is arranged to be sensed, so as to determine a mutual capacitance between adjacent drive electrodes and sense electrodes,
the drive conductive lines and the sense conductive lines being arranged in an array form.

The method according to the invention comprises the steps of:
- measuring mutual capacitances between adjacent drive electrodes and sense electrodes, when the button is in the unclicked state, so as to have a mutual capacitance reference measurement frame,
- measuring mutual capacitances between adjacent drive electrodes and sense electrodes, so as to have a mutual capacitance current measurement frame.

In this context, a mutual capacitance (reference or current) measurement frame is an array of (reference or current) values of the mutual capacitances of the sensor layer of the capacitive touch device.

In the method according to the invention, if the button is in the clicked state, a drive electrode associated to a first lower contact of the button is connected via a switch member of the button with a non-adjacent sense electrode associated to a second lower contact of the button, so as to modify at least a value of a mutual capacitance facing one of the lower contacts.

The method according to the invention comprises the step of comparing the current measurement frame with the reference measurement frame:
- if the current measurement frame is equal to the reference measurement frame, then the button is in the unclicked state,
- if the current measurement frame is different from the reference measurement frame, then the button is in the clicked state.

The current measurement frame is different from the reference measurement frame if at least one value of the mutual capacitance of the current measurement frame is different from the value of the corresponding mutual capacitance of the reference measurement frame. In one preferred embodiment, the current measurement frame is different from the reference measurement frame if some values of the mutual capacitance of the current measurement frame below the contact point between the button and the user are different from the values of the corresponding mutual capacitance of the reference measurement frame.

In one embodiment, the method comprises the step of determining a position of the click, on the basis of the modified value of the mutual capacitance.

### Short description of the drawings

Exemplar embodiments of the invention are disclosed in the description and illustrated by the drawings in which:
Figure 1 illustrates a perspective view of a button according to one embodiment of the invention.
Figure 2 illustrates a perspective view of some parts of the button of Figure 1, without the activation member.
Figure 3 illustrates a perspective view of some parts of the button of Figure 1 without the activation member and the switch member.
Figure 4 illustrates a cut view of the button of Figure 1 along the line II-II of Figure 1.
Figure 5 illustrates a top view of the contact member of the button of Figure 1.
Figure 6 illustrates a bottom view of the contact member of Figure 5.
Figure 7 schematically illustrates a cut view of the button and of the capacitive touch device, so as to representing the working of the system according to the invention.
Figure 8 schematically illustrates a top view of the sensor layer, when the button is in the unclicked state.

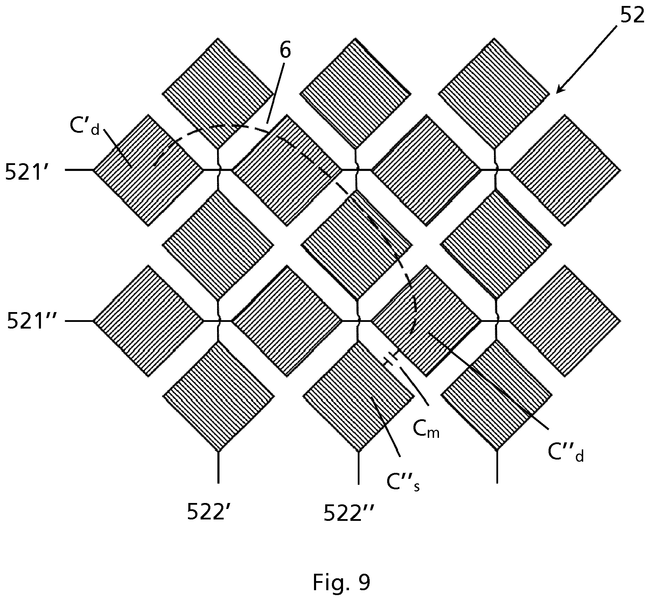

Figure 9 schematically illustrates a top view of the sensor layer of Figure 8, when the button is in the clicked state.
Figure 10A illustrates a perspective view of buttons according to another embodiment of the invention.
Figure 10B illustrates a perspective view of buttons according to another embodiment of the invention.
Figure 11A illustrates a top view of the buttons of Figure 10A.
Figure 11B illustrates a top view of the buttons of Figure 10B.
Figure 12A illustrates a bottom view of the buttons of Figure 10A.
Figure 12B illustrates a top view of the buttons of Figure 10B.
Figure 13A illustrates a top view of the contact member for the buttons of Figures 10A or 10B.
Figure 13B illustrates a bottom view of the contact member of the Figure 13A.

### Examples of embodiments of the present invention

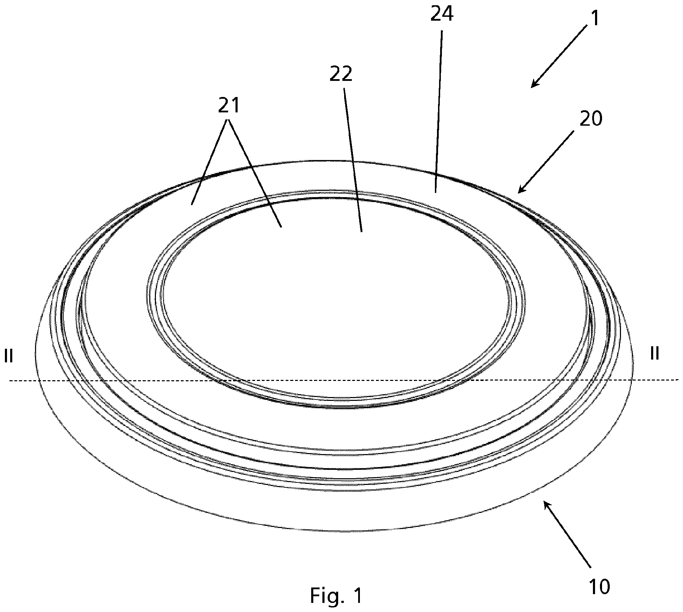

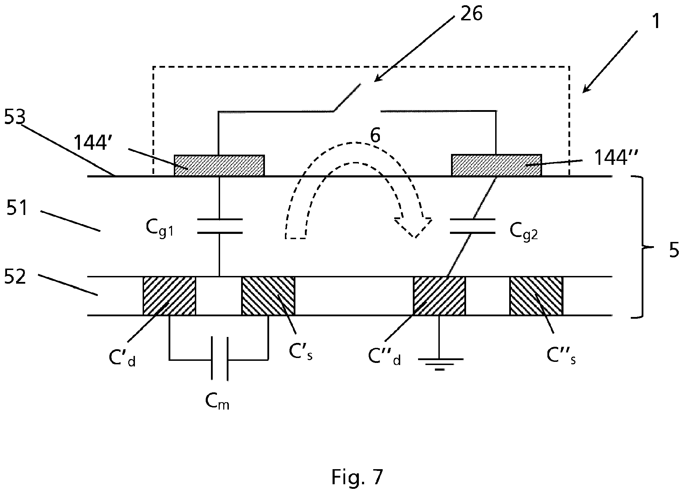

Figure 1 illustrates a perspective view of a button 1 according to one embodiment of the invention. The button 1 according to the invention is configured to be placed on a capacitive touch surface 53 of a capacitive touch device 5 (visible e.g. in Figure 7). It is also configured to allow the capacitive touch device 5 to detect a clicked state and an unclicked state of the button 1.

The capacitive touch device 5 is illustrated in Figure 7 and comprises:
- a display layer 51, made by glass or any other suitable material, on which the button 1 according to the invention is placed, and
- a sensor layer 52, made e.g. by ITO or any other suitable material, placed under the display layer 51, i.e. on a surface opposite to the surface facing the button 1.

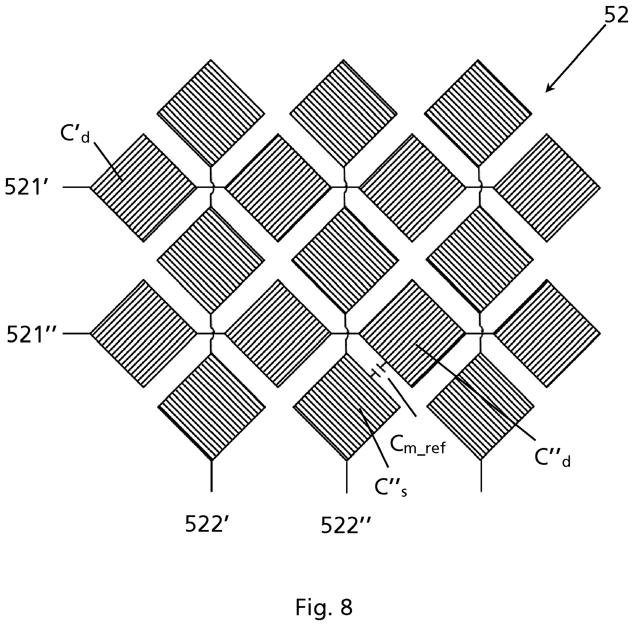

Figure 8 illustrates schematically a (partial) top view of the sensor layer 52, when the button 1 is in the unclicked state. The sensor layer 52 comprises:
- drive conductive lines 521', 521", wherein each line serially connects drive electrodes and is arranged to receive a drive signal, and
- sense conductive lines 522', 522", wherein each line serially connects sense electrodes and is arranged to be sensed, so as to determine mutual capacitances between adjacent drive electrodes and sense electrodes.

In the example of Figure 8, for simplicity, only the mutual capacitance Cm_ref between the adjacent electrodes C"d (drive electrode) and C"s (sense electrode) has been illustrated.

The mutual capacitance Cm_ref and the other mutual capacitances between the adjacent drive and sense electrodes are measured at the sensing of the sense conductive lines 522', 522", and the result of this measurement is a mutual capacitance reference measurement frame.

The drive conductive lines 521', 521" and the sense conductive lines 522', 522" are arranged in an array. The drive conductive lines 521', 521" are arranged in a first direction and the sense conductive lines 522', 522" are arranged in a second direction. In the (non-limitative) example Figure 8, the second direction is perpendicular to the first direction.

Each touch pixel of the capacitive touch device 5 can be identified by the corresponding drive and sense conductive lines. Each touch pixel is in particularly formed by a mutual capacitive connection between one drive electrode and the adjacent sense electrode.

The capacitive touch device is configured to measure the capacitance between adjacent drive and sense electrodes, e.g. in subsequent distinct time windows of one sampling period. Once the capacitance is measured, a touch frame of the measurements of all touch pixels within one sampling period is created, so as to detect the presence and/or the position of an object on the capacitive touch surface 53.

Preferably, the sensor layer 52 is configured for passively detecting positions of a passive object on the capacitive touch surface 53. In one embodiment, a passive detection can be achieved by applying a driving signal on the touch pixels of a drive conductive line 521' or 521" and by measuring (sequentially or at the same time) the output of sense conductive line(s) 522', 522". The driving signal is applied sequentially to each (and/or only one) of the drive conductive lines 521', 521" so that the output signal for each combination of drive and sense conductive lines, thus for each touch pixel, can be measured. Based on the output signals for each touch pixel, the mutual capacitance value of each touch pixel of the sensor layer (and in the touch frame) can be measured.

If the mutual capacitance value goes under (or over) a certain threshold, a touch is detected at this touch pixel. Therefore, the touch sensor comprises preferably a driving circuit (not illustrated) for driving the drive conductive lines 521', 521" and a sensing circuit (not illustrated) for measuring the output of the sense conductive lines 522', 522". The driving circuit is connected to the drive conductive lines 521', 521" for sequentially applying a driving signal at the drive conductive lines 521', 521". The sensing circuit is connected to the sense conductive lines 522', 522" for measuring for each drive conductive lines 521', 521" the output of all sense conductive lines 522', 522". Preferably, the sensing circuit comprises at least one charge sensor and at least one digital to analogue converter. An example of a sensing circuit is described in the document EP2617132, filed by the applicant.

Referring back to Figure 1, the button 1 according to the invention comprises:
- a support member 10, and
- an activation member 20.

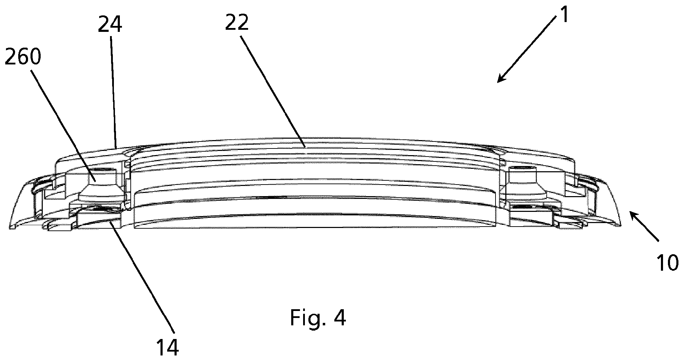

The support member 10 is configured to face the capacitive touch surface 53, and comprises a contact member 14, visible e.g. in Figures 3 to 6.

In one embodiment, the button 1 is mounted in a fixed manner on the capacitive touch surface 53, e.g. glued on the capacitive touch surface 53. In another embodiment, the support member 10 is fixed in a non-removably/non-detachably manner on the capacitive touch surface 53. Preferably, the support member 10 is glued on the capacitive touch surface 53. In an alternative embodiment, the support member 10 can be fixed in a removably/detachably manner. This can be realised by simply placing the button 1 with the support 10 on the capacitive touch surface 53 such that the support member 10 is fixed by the gravity and/or friction. This can be improved by a high friction surface on the support surface of the support 10, i.e. the surface of the support 10 facing the capacitive touch surface 53. This can also be realised by detachable fixation mechanisms like a suction surface on the support surface.

The button 1 is described in the as fixed to the capacitive touch device 5. The button 1 is however also protected without the capacitive touch device 5. The button 1 is then configured to be fixed to the (flat) capacitive touch surface 53 of the capacitive touch device 1.

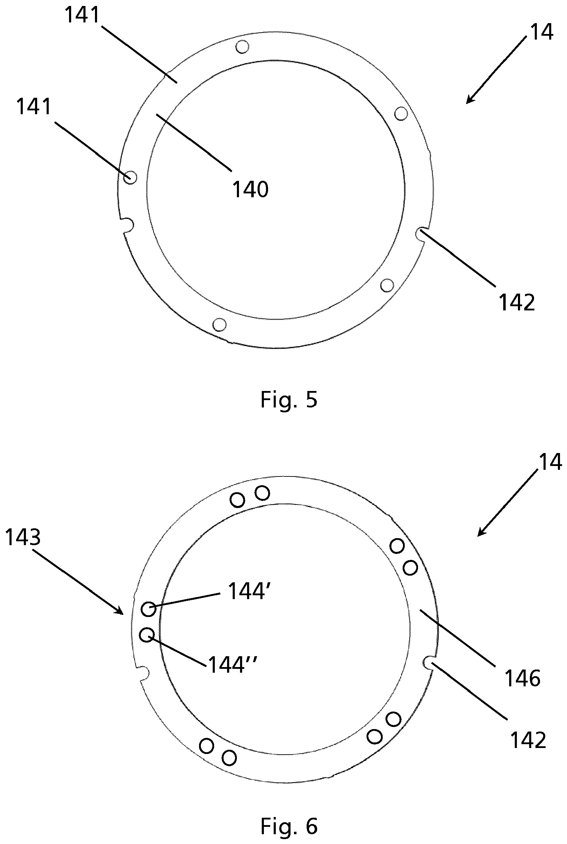

The contact member 14 comprises:
- an upper surface 140, visible in Figure 5, configured to face in this embodiment the activation member 20, and
- a lower surface 146, visible in Figure 6, configured to be placed on (and preferably to directly touch) the touch sensor surface 53.

According to the invention, the lower surface 146 of the contact member 14 comprises at least a couple 143 of lower contacts 144', 144" (five couples 143 are illustrated in the example of Figure 6).

According to the invention, the lower contacts 144', 144" are arranged so that one lower contact of the couple 143 faces a drive electrode (e.g. the drive electrode C'd in Figure 8) and the other lower contact of the couple faces a non-adjacent sense electrode, (e.g. the sense electrode C"s in Figure 8).

In this context, a sense electrode non-adjacent with a drive electrode is a sense electrode not forming with this drive electrode a touch pixel as discussed here above. On the contrary, this context, a sense electrode adjacent with a drive electrode is a sense electrode forming with this drive electrode a touch pixel as discussed here above, i.e. a mutual capacitance whose value is sensed by the capacitive touch device so as to detect a touch.

In other words, a sense electrode non-adjacent with a drive electrode is a sense electrode not belonging on the same horizontal line (drive conductive line) or vertical line (sense conductive line) of the drive electrode.

In the embodiment of Figure 5, the upper surface 140 of the contact member 14 comprises also one or more upper contacts 141. In the embodiment of Figure 5, each upper contact 141 is associated with a couple 143 of lower contacts 144', 144" on the opposed surface.

The upper and lower contacts of the contact member 14 are (at least partially) conductive.

Although in Figures 5 and 6, upper and lower contacts of the contact member 14 have been illustrated by circles, this is not limitative and they can have any other shape, including e.g. squared, rectangular or polygonal shape. Moreover, it is not necessary that upper and lower contacts of the contact member 14 have all the same size.

In the embodiment of Figures 5 and 6, the contact member 14 comprises orientations elements 142, e.g. notches, cooperating with corresponding orientations elements 12 of the support member 10, e.g. pins, visible e.g. in Figure 3. In other words, in one embodiment, the support member 10 is keyed, so as to receive the contact member 14 only in one orientation. This is important in particular if the button has a circular shape, as in the embodiment of Figures 1 to 6.

In the embodiment of Figures 1 to 6, the contact member 14 and the support member 10 are arranged so that the contact member 14 can be received by the support member 10, without requiring any fixation means between the contact member 14 and the support member 10. In this case, the contact member 14 can have a smaller size than the support member 10 (e.g., in the embodiment of Figures 1 to 6, the diameter of the contact member 14 is smaller than the diameter of the support member 10).

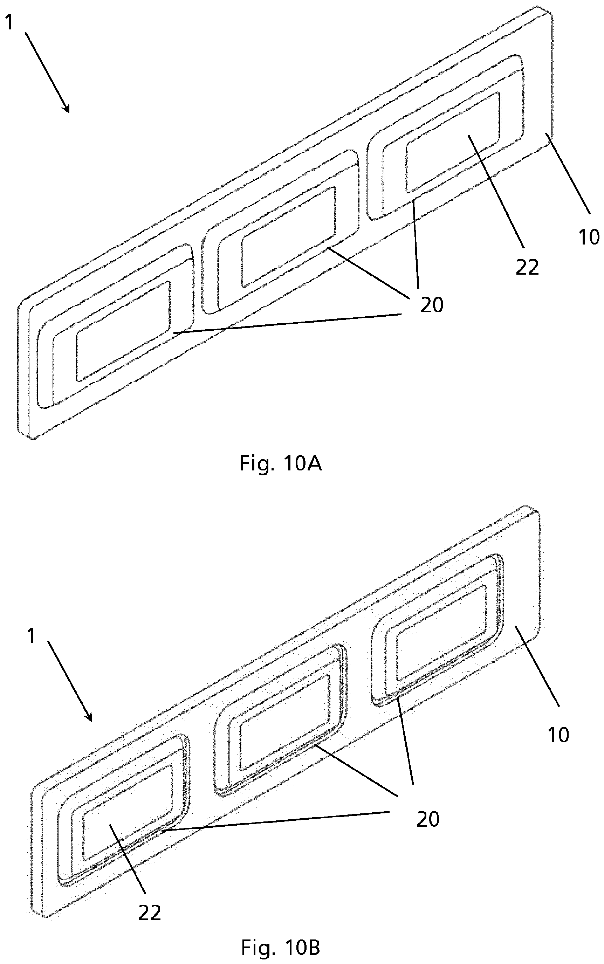

In another embodiment, the contact member 14 can be fixed to the support member 10, e.g. by an adhesive film or a glue. The fixation can be movable or not. In this case, the contact member 14 can have a similar or equal size than the support member 10, as in the case of Figures 10A to 13B.

In one preferred embodiment the contact member 14 is a PCB (Printed Circuit Board). This embodiment is simple and cheap to realize. In one preferred embodiment the contact member 14 is a ring-shaped PCB.

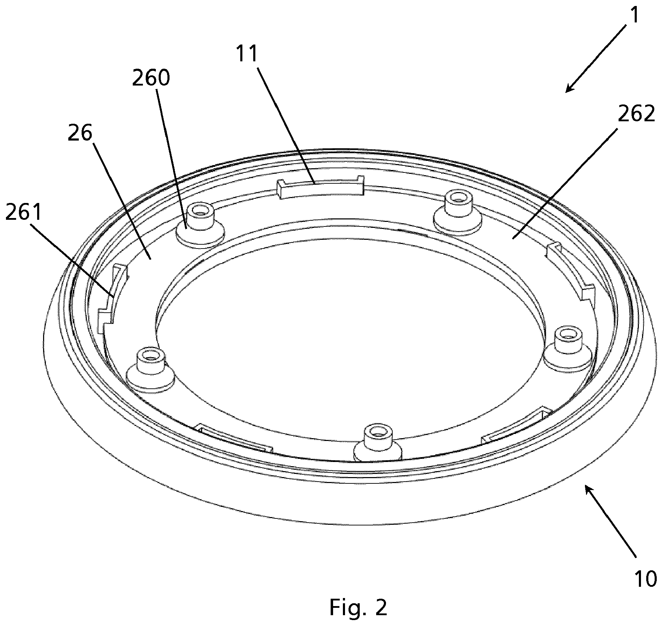

The activation member 20 of the button 1 according to the invention is movable by a user relative to the support member 10. In particular, the activation member 20 in the clicked state is moved closer to the support member 10 than in the unclicked state. According to the invention, the activation member 20 comprises:
- a user contact surface 21, visible e.g. in Figure 1, which is configured to be touched by a user for moving the activation member 20, thereby actuating the button 1, and
- a switch member 26, visible e.g. in Figure 2.

In one preferred embodiment, the user contact surface 21 is (at least partially) transparent, so as to transfer information displayed on the touch sensor surface 53 under the user contact surface 21 to the user. In the example of Figure 1, the user contact surface 21 comprises a central portion 22 which is transparent and a peripheral portion 24 which is not-transparent.

In one preferred embodiment, the user contact surface 21 is non-conductive, e.g. made of plastics. For example, both the central portion 22 and the peripheral portion are non-conductive. This embodiment as well is simple and cheap to realize.

In one embodiment, the switch member 26 is configured to provide a haptic click feedback and/or an acoustic click feedback, when the button changes from the unclicked state to the clicked state and/or vice-versa. In one preferred embodiment, it comprises elastic elements 260, as dome springs.

In one preferred embodiment, the switch member 26 comprises several conductive elements (not illustrated). In one embodiment, each conductive element is in (the body of) an elastic element 260.

In one embodiment, each conductive element (or each elastic element 260 if the conductive element is in the elastic element 260) faces an upper contact 141 of the contact member 14. In one embodiment, each conductive element in the clicked state is moved closer to the corresponding upper contact 141 than in the unclicked state. In one embodiment, each conductive element in the clicked state directly touches (i.e. directly enters into contact with) the corresponding upper contact 141.

In the embodiment of Figure 2, the switch member 26 comprises a body 262 connecting the elastic element 260. In one embodiment, the body 262 and the elastic elements 260 are made of the same (elastic) material, e.g. rubber. This embodiment as well is simple and cheap to realize.

Although in Figure 2 five elastic elements 260 (and then five conductive element) have been illustrated, this is not limitative and any number of elastic elements 260 and/or of conductive elements can be used. In one preferred embodiment, at least three elastic elements 260 and/or at least three conductive elements are used.

Although in Figure 2 all the elastic elements 260 have the same shape and size, this is not-limitative: in other (not-illustrated) embodiments, the elastic elements 260 have different shape and/or size.

Although in the embodiment of Figure 2, the switch member 26 has a shape and a size similar or equal to the shape respectively the size of the contact member 14, this is not-limitative: in other (not-illustrated) embodiments, the switch member 26 has different shape and/or size different from the shape respectively the size of the contact member 14.

In the embodiment of Figures 1 to 6, the switch member 26 is configured to conductively connect, e.g. by a short-circuit or by an ohmic path, the lower contacts of the couple 143 via the associated upper contact 141. This allows to close a charge path 6, illustrated e.g. in Figure 7, from the drive electrode C'd respectively C"d to the non-adjacent sense electrode C"s respectively C's facing the lower contacts 144', 144" of the couple 143, when the button 1 is in the clicked state.

The switch member 26 is also configured to conductively separate the lower contacts 144', 144" of the couple 143, when the button 1 is in the unclicked state, so as to open the charge path 6.

According to the invention, a mutual capacitance Cm facing one of the lower contacts 144', 144" of the couple is modified once the charge path 6 is closed respectively opened, thereby allowing the capacitive touch device 5 to detect the clicked state respectively the unclicked state of the button 1.

In one embodiment, the capacitive touch device is arranged so as to determine a position of the click, on the basis of the modified value of the mutual capacitance Cm.

In particular, as illustrated in Figure 7, the charge path 6 comprises a first capacity Cg1 of the display layer 51, the button 1 (in particular the conductive connection between the two lower contacts 144', 144" via the switch member 26), and the second capacity Cg2 of the display layer 51. This charge path 6 is grounded via a drive electrode (C'd in Figure 7) when the sense conductive line(s) are sensed.

Although in the embodiment of Figures 1 to 6 the conductive connection between the two lower contacts 144', 144" is realized by the switch member 26 via the corresponding upper contact 141, this is not limitative for the invention, as other arrangements allowing to conductively connect the two lower contacts 144', 144" via a switch member 26, without requiring the use of the upper contact 141, are possible.

In one preferred embodiment, the capacity of the display layer 51, in particular the capacity Cg2, should be as high as possible, so as to reduce the impedance of the charge path 6 toward the ground. This would require a short (physical) distance between the drive electrode facing a lower contact of the couple 143 and the non-adjacent sense electrode facing the other lower contact of the couple 143. On the other hand, this distance should not be too short, so as to avoid the interaction with the mutual capacitance between the drive electrode facing a lower contact of the couple 143 and an adjacent sense electrode.

In one preferred embodiment, the drive electrode facing one lower contact of the couple 143 is separated by two drive conductive lines and two sense lines from the non-adjacent sense electrode facing the other lower contact of the couple 143. The applicant has found this distance as a good compromise so as to both reduce the impedance of the charge path 6 toward the ground, and also to avoid the interaction with the mutual capacitance between the drive electrode facing a lower contact of the couple and an adjacent sense electrode.

Figure 10A and 10B illustrate a perspective view of buttons 1 according to another embodiment of the invention. In both the illustrated embodiments, a single (monobloc) support member 10 cooperates with more activation members 20 (three in the example). In another (not illustrated) embodiment, there are different support members 10 for the activation members 20.

In both the illustrated embodiments, the activation members 20 have a rectangular shape. However, this form is not limitative. Moreover, each activation members 20 on the same support member 10 can have different shape and/or size.

Some activation members 20 the same support member 10 can have a transparent central portion 22, others can be not-transparent.

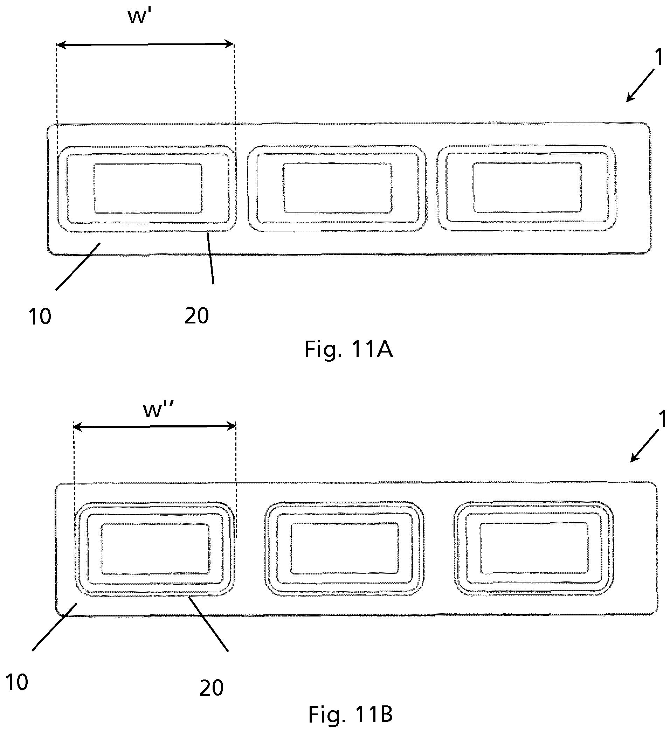

In one embodiment, the width w' of the activation member 20 of the embodiment of Figure 10A, visible in Figure 11A, is larger than the corresponding width w" of the activation member 20 of the embodiment of Figure 10A, visible in Figure 11B.

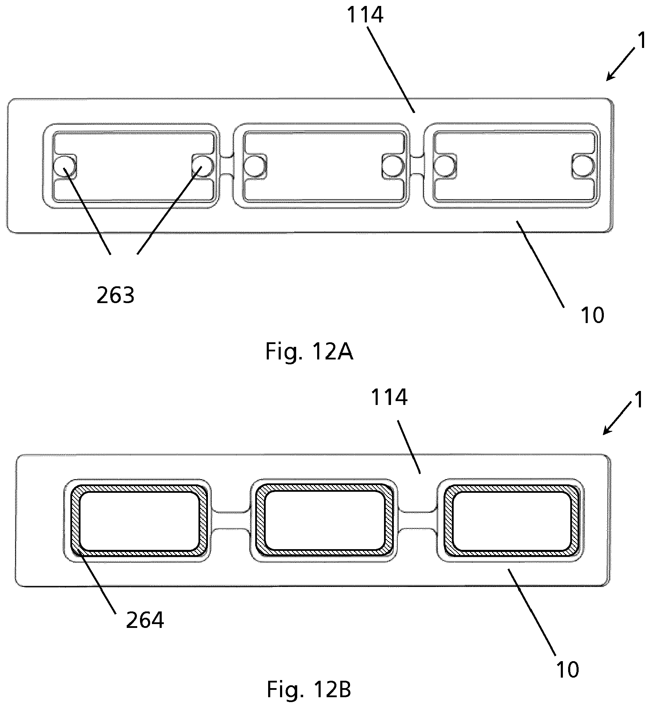

This is related to the fact that the conductive elements of the buttons of Figure 10A, visible in Figure 12A, are (at least partially) conductive pads 263, placed on the periphery of the surface of the activation member 20 facing the contact member 14. In the embodiment of Figure 12A, the pads 263 of each activation member 20 face each other. The conductive elements of the buttons of Figure 10B, visible in Figure 12B, are a conductive film 264 placed along the whole periphery of the surface of the activation member 20 facing the contact member 14. In one embodiment, the conductive film 264 is transparent. The presence of this conductive film 264 along the whole periphery of the surface of the activation member 20 facing the contact member allows to increase the size of the activation member 20 with regard to the embodiment in which (discrete) conductive elements 263 are used, e.g. to increase its width (w" > w').

In the embodiment of Figure 12A, each activation member is associated with two conductive pads 263, facing each other. This redundancy allows to detect a clicked state of the button independently on the fact that the button is pressed on its left or on its right side.

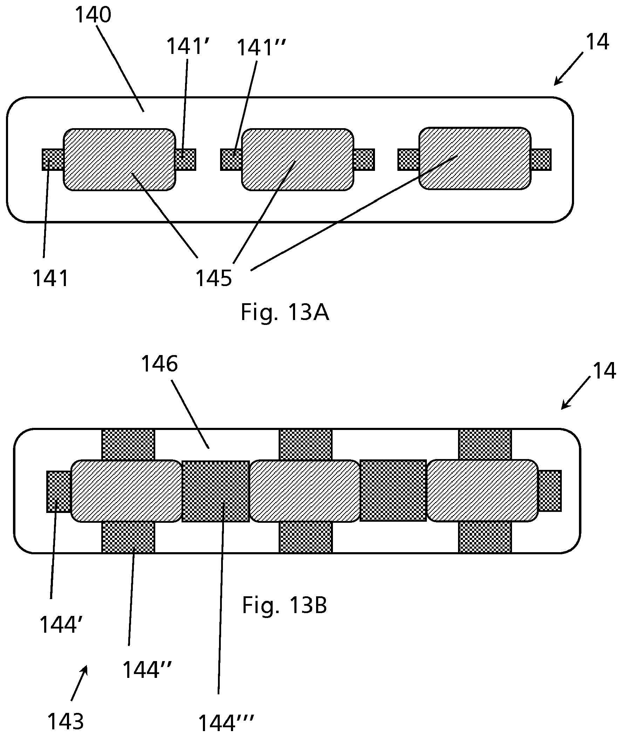

Figure 13A illustrates a top view of the contact member 14 which can be used for the buttons of Figures 10A or 10B. In the illustrated embodiment, the contact member 14 is a PCB, comprising through holes 145, in correspondence with the respective activation members 20.

In this embodiment, the size and the shape of the contact member 14 are substantially identical to the size respectively the shape of the support member 10.

The contact member 14 is arranged to be connected to the support member 10, e.g. via an adhesive layer placed on the surface 114 of the support member 10 facing the contact member 14. In another (not illustrated) embodiment, the contact member 14 is arranged to be connected to the support member 10 via an adhesive layer placed on the surface 140 of the contact member 14 facing in this case the support member 10.

In the embodiment of Figure 13A, the upper surface 140 of the contact member 14 comprises one or more upper contacts 141. In the embodiment of Figure 13A, each upper contact 141 is associated with a couple 143 of lower contacts 144', 144" on the opposed surface, visible in Figure 13B.

The upper and lower contacts of the contact member 14 are (at least partially) conductive.

Although in Figures 13A and 13B, upper and lower contacts of the contact member 14 have been illustrated by squares or rectangles, this is not limitative and they can have any other shape, including e.g. circular or polygonal shape. Moreover, it is not necessary that upper and lower contacts of the contact member 14 have all the same size.

In the embodiment of Figure 13B, one lower contact can be associated with two upper contacts 141. For example, the lower contact 144'" is associated with two upper contacts 141' and 141". This is especially the case where the two key together function (i.e. while both buttons are pressed together) is not desired.

The sizes and proportions indicated in the Figures are only indicative and have in some cases been modified to improve the clarity of the figures. They are not at all limitative nor necessarily representing the real sizes and proportions.

### Reference signs used in the figures

- 1: Button
- 5: Capacitive touch device
- 6: Charge path
- 10: Support member
- 11: First orientation element of the support member
- 12: Second orientation element of the support member
- 14: Contact member
- 20: Activation member
- 21: User contact surface
- 22: (Transparent) central portion
- 24: Peripheral portion
- 26: Switch member
- 51: Display layer
- 52: Sensor layer
- 53: Capacitive touch surface
- 521', 521": Drive line
- 522', 522": Sensor line
- 114: Surface of the support member facing the contact member
- 140: Upper surface of the contact member
- 141, 141', 141": Upper contact
- 142: Orientation element of the contact member
- 143: Couple of lower contacts
- 144', 144", 144'": Lower contact
- 145: Through hole
- 146: Lower surface of the contact member
- 260: Elastic element (dome spring)
- 261: Orientation element of the switch member
- 262: Body of the switch member
- 263: Conductive element of the switch member
- 264: Conductive film
- C'_{d}, C"_{d}: Drive electrode
- C'ₛ, C"ₛ: Sense electrode
- C_{g1}, C_{g2}: Glass capacity
- Cₘ: Mutual capacity
- C_{m_ref}: Reference mutual capacity
- w', w": Width of the activation member

## Claims

1. System for detecting a clicked state and an unclicked state of a button (1), comprising
- said button (1);
- a capacitive touch device (5),
wherein said button (1) is configured to be placed on a capacitive touch surface (52) of said capacitive touch device (5) and configured to allow the capacitive touch device (5) to detect a clicked state and an unclicked state of the button (1),
wherein the capacitive touch device (5) comprises:
- drive conductive lines (521', 521"), wherein each line serially connects drive electrodes and is arranged to receive a drive signal,
- sense conductive lines (522', 522"), wherein each line serially connects sense electrodes and is arranged to be sensed, so as to determine mutual capacitances (Cm) between adjacent drive electrodes and sense electrodes, wherein the drive conductive lines (521', 521") and the sense conductive lines (522', 522") are arranged in an array form,
wherein the button (1) comprises:
- a support member (10) configured to face the capacitive touch surface (53), wherein the support member (10) comprises a contact member (14) comprising:
- a lower surface (146) configured to be placed on the touch sensor surface (53), and comprising at least a couple (143) of lower contacts (144', 144"),
wherein the lower contacts (144', 144") are arranged so that one lower contact (144') of the couple (143) faces a drive electrode (C'd) and the other lower contact (144") of the couple (143) faces a non-adjacent sense electrode (C"s),
- an activation member (20), which is movable by a user relative to the support member (10), wherein the activation member (20) in the clicked state is moved closer to the support member (10) than in the unclicked state,
wherein the activation member (20) comprises:
- a user contact surface (21) which is configured to be touched by a user for moving the activation member (20), thereby actuating the button,
- a switch member (26), configured to
- conductively connect the lower contacts (144', 144") of the couple (143), thereby closing a charge path (6) from the drive electrode (C'd) and the non-adjacent sense electrode (C's) facing the lower contacts (144', 144") of the couple (143), when the button (6) is in the clicked state,
- conductively separate said lower contacts (144', 144") of the couple (143), when the button (1) is in the unclicked state, so as to open said charge path (6),
wherein a mutual capacitance (Cm) facing one of the lower contacts of the couple (143) is modified once the charge path (143) is closed respectively opened, thereby allowing the capacitive touch device (5) to detect the clicked state respectively the unclicked state of the button (1).

2. The system of claim 1, wherein said mutual capacitance (Cm) has a first value, when the button is in the clicked state, and a second value, different from the first, when the button is in the unclicked state, wherein the capacitive touch device is arranged to detect the clicked state respectively the unclicked state of the button based on the first respectively the second value.

3. The system of one of claims 1 or 2, wherein the contact member (14) comprises an upper surface (140) opposite to the lower surface (146), the upper surface comprising one or more upper contacts (141).

4. The system of claim 3, wherein each upper contact (141) is associated with a couple (143) of lower contacts (144', 144").

5. The system of one of claims 3 or 4, wherein the switch member (26) comprises conductive element(s) (263, 264), each conductive element (263, 264) facing an upper contact (141) of the contact member (14).

6. The system of claim 5, wherein each conductive element (263, 264) is arranged so as to conductively connected the lower contacts (144', 144") of the couple (143) via the associated upper contact (141), when the button (10) is in the clicked state.

7. The system of one of claims 5 or 6, wherein the switch member (26) comprises a body (262) comprising conductive element(s) (263).

8. The system of one of claims 5 to 8, wherein each conductive element (263) is a pad.

9. The system of one of claims 5 or 6, wherein the conductive element is a conductive film (264) along the whole periphery of the surface of the activation member (20) facing the contact member (14).

10. The system of one of claims 1 to 9, wherein the switch member is configured to provide an haptic click feedback and/or an acoustic click feedback, when the button (1) changes from the unclicked state to the clicked state and/or vice-versa.

11. The system of claim 10, wherein the switch member comprise an elastic element as a dome spring (260).

12. The system of one of claims 1 to 11, wherein the user contact surface (21) is non-conductive.

13. The system of one of claims 1 to 12, wherein the contact member (14) is a PCB.

14. The system of one of claims 1 to 13, wherein the support member (10) is keyed, so as to receive the contact member (14) only in one orientation.

15. Method for allowing a capacitive touch device (5) to detect a clicked state and an unclicked state of a button (1) configured to be placed on a capacitive touch surface (53) of said capacitive touch device (5),
wherein the capacitive touch device (5)comprises:
- drive conductive lines (521', 521"), wherein each line serially connects drive electrodes and is arranged to receive a drive signal,
- sense conductive lines (522', 522"), wherein each line serially connects sense electrodes and is arranged to be sensed, so as to determine a mutual capacitance (Cm) between adjacent drive electrodes and sense electrodes, wherein the drive conductive lines (521', 521") and the sense conductive lines (522', 522") are arranged in an array form,
the method comprising the steps of:
- measuring mutual capacitances between adjacent drive electrodes and sense electrodes, when the button (1) is in the unclicked state, so as to have a mutual capacitance reference measurement frame,
- measuring mutual capacitances between adjacent drive electrodes and sense electrodes, so as to have a mutual capacitance current measurement frame,
wherein, if the button (1) is in the clicked state, a drive electrode (C'd) associated to a first lower contact (144') of the button (1) is connected via a switch member (26) of the button (1) with a non-adjacent sense electrode (C"s) associated to a second lower contact (144") of the button (1), so as to modify at least a value of a mutual capacitance (Cm) facing one of the lower contacts,
- comparing the mutual capacitance current measurement frame with the mutual capacitance reference measurement frame, wherein:
- if the mutual capacitance current measurement frame is equal to the mutual capacitance reference measurement frame, then the button (1) is in the unclicked state,
- if the mutual capacitance current measurement frame is different from the mutual capacitance reference measurement frame, then the button (1) is in the clicked state.
